# EUROPÄISCHE PATENTANMELDUNG

(11) **EP 0 647 523 A1**
(43) Veröffentlichungstag der Anmeldung: **12.04.1995**
(21) Anmeldenummer: 94202862.2
(22) Anmeldetag: 04.10.1994
(51) Int. Cl.: B32B 18/00, H01G 4/12, H01G 4/30

(54) **Schichtverbundfolie, Mehrfarbensiebdruckverfahren zu ihrer Herstellung und ihre Verwendung**

(30) Priorität: 06.10.1993 DE 4334059
(71) Anmelder: Philips Patentverwaltung GmbH, 22335 Hamburg (DE); PHILIPS ELECTRONICS N.V., 5621 BA Eindhoven (NL)
(72) Erfinder: Warnier, Jacques, Ing., c/o Philips, D-20097 Hamburg (DE); van der Beek, Gerrit, Dr., c/o Philips, D-20097 Hamburg (DE); Weerts, Hubertus, c/o Philips, D-20097 Hamburg (DE)
(74) Vertreter: Volmer, Georg, Dipl.-Ing.

(57) **Zusammenfassung**

Die Erfindung betrifft eine Schichtverbundfolie, insbesondere zur Herstellung von passiven elektronischen Bauelementen mit Vielschichtstruktur, ein Mehrfarbensiebdruckverfahren zu ihrer Herstellung und ihre Verwendung zur Herstellung passiver elektronischer Bauelemente, wobei die Schichtdicke der Schichtverbundfolie dünn und gleichmäßig ist, die Schichtstruktur verbessert ist und das Herstellungsverfahren vereinfacht ist.
Erfindungsgemäß wird eine Schichtverbundfolie vorgeschlagen, die eine grüne keramische Substratfolie, im Siebdruck aufgebrachte innere Elektroden und eine oder mehrere ganzflächig über die grüne keramische Substratfolie und die inneren Elektroden im Siebdruck aufgebrachte Ausgleichsschichten umfaßt.
Die inneren Elektroden und die Ausgleichsschicht oder - schichten werden nacheinander auf die grüne keramische Substratfolie im Siebdruck aufgebracht.

## Beschreibung

Die Erfindung betrifft eine Schichtverbundfolie, insbesondere für passive elektronische Bauelemente mit Vielschichtstruktur.

Sie betrifft weiterhin ein Mehrfarbensiebdruckverfahren zur Herstellung solcher Schichtverbundfolien sowie deren Verwendung.

In der elektronischen Industrie werden viele passive Bauelemente in einer Vielschichtstruktur hergestellt. Dazu zählen beispielsweise Vielschichtkondensatoren, -aktuatoren und -varistoren.

Mengenmäßig am meisten werden Vielschichtkondensatoren hergestellt. Ein Vielschichtkondensator nach dem Stand der Technik besteht aus einem laminierten Stapelverbund dünner, keramischer, dielektrischer Schichten, zwischen denen innere Elektroden liegen. Die inneren Elektroden sind durch äußere Kontakte miteinander verbunden.

Vielschichtaktuatoren und -varistoren haben ein analoges Bauprinzip, für das "grüne" (ungebrannte) keramische Substratfolien mit darauf aufgebrachten metallischen Strompfaden zu einem komplexen dreidimensionalen Verbund zusammengesintert werden.

Üblicherweise werden zur Herstellung passiver elektronischer Bauelemente mit Vielschichtstruktur zunächst grüne keramische Substratfolien aus meist dielektrischen keramischen Komponenten und Bindemittelzubereitungen hergestellt.

Auf diese Substratfolien werden die inneren Elektroden aufgebracht, indem die grüne Keramik mit einer Metallisierungspaste in dem Elektrodenmuster beschichtet wird. Diese metallisierten grünen Substratfolien werden gestapelt, der Stapel wird zu einer Halbzeugplatte laminiert. Die Halbzeugplatten werden in die gewünschten Produkte getrennt. Dann wird zunächst der Binder ausgebrannt, dann die Keramik gesintert. Anschließend werden die äußeren Elektroden aufgebracht.

Wenn jedoch metallisierte, grüne keramische Substratfolien der oben beschriebenen Art und Weise gestapelt werden, wird eine Halbzeugplatte erhalten, in der die Dicke der Bereiche mit Metallisierung wesentlich größer ist als die der Bereiche ohne Metallisierung. Dieses ist Anlaß zu störenden Effekten beim Verpressen der Stapel.

Ist die Schichtdicke der Substratfolie in Relation zur Schichtdicke der Elektroden um ein Vielfaches größer, so machen sich die auf der alternierenden Schichtdicke beruhenden Effekte nicht so sehr bemerkbar. Die relativ dicke Substratfolie wird beim Pressen der Stapel in die Zwischenräume zwischen den Elektroden gequetscht. Sie füllt diese Zwischenräume aus und die vertikale Stapelordnung der Elektroden bleibt beim Pressen der Stapel im wesentlichen erhalten.

Die fortlaufende Miniaturisierung passiver Bauelemente führt aber zu immer dünneren Substratfolien, bei denen die Schichtdicke der Folien in der Größenordnung der inneren Elektroden liegt. Diese dünnen Folien können beim Verpressen der Stapel die Zwischenräume zwischen den übereinanderliegenden inneren Elektroden nicht vollständig ausgleichen.

Bei einem solchen Stapelaufbau ist es zwangsläufig, daß beim Pressen Scherkräfte auftreten und sich die einzelnen Folien gegeneinander verschieben. Im Querschnitt gesehen ordnen sie sich häufig zu einem unregelmäßiges Schlangenmuster ("chevronning")an. Die inneren Elektroden liegen dann nicht mehr paßgenau übereinander. Dadurch ist die exakte Positionierung der Trennschnitte für die Trennung der Platte in einzelne Produkte erschwert.

Andererseits können beim Zusammenpressen der metallisierten, grünen Substratfolien aufgrund der alternierenden Schichtdicke auch Lunker zwischen ihnen stehen bleiben, die beim Brennen und Sintern nicht mehr ausheilen. Dies kann Delaminationen während der Fertigung verursachen oder zum vorzeitigen Produktausfall führen.

Es sind deshalb schon verschiedene Wege vorgeschlagen worden, den Schichtaufbau für passive elektronische Bauelemente mit Vielschichtstruktur zu verbessern.

Aus der JP 3-105 905 ist bereits ein Verfahren zur Herstellung einer homogenen grünen Folie mit gleichmäßiger Dicke bekannt, bei dem eine erste Paste für die kontinuierliche Fertigung von inneren Elektroden auf eine gerollte Substratfolie siebgedruckt wird.

Dann wird eine zweite keramische Paste zur Fertigung einer dielektrischen Schicht zwischen dem Muster der inneren Elektroden durch dasselbe Druckverfahren, das für die inneren Elektroden angewandt wurde, auf den Teil der gerollten Folie aufgedruckt, wo die inneren Elektroden nicht aufgedruckt wurden, nachdem eine sorgfältige Positionierung mit Hilfe von Anschlaglöchern in der Folie vorgenommen wurde.

Nach dem Drucken der zweiten Paste wird auf der bedruckten Oberfläche ein Film aus keramischem Schlicker nach dem "doctor blade"-Verfahren gebildet.

Danach wird die Folie getrocknet, in Stücke geschnitten, gelocht und laminiert. Das fertige Teil wird noch kalziniert.

Dies Verfahren hat den Nachteil, daß das Drucken mit der zweiten keramischen Paste zwischen den inneren Elektroden ein sehr genaues Positionieren des Siebes erfordert. Es läßt sich kaum vermeiden, daß bei nicht genauer Positionierung der Siebschablonen zwischen inneren Elektroden und den dazwischen aufgedruckten dielektrischen Stegen schmale unbedruckte Zwischenräume und Hinterschneidungen stehen bleiben, die auch beim nachträglichen Überstreichen mit keramischer Masse nicht mehr mit Material gefüllt werden.

Ebenso unerwünscht, aber schwer zu vermeiden, sind Drucküberlappungen, die zu Unebenheiten in der Schichtfolienoberfläche führen.

Ein weiterer Nachteil besteht darin, daß zur Fertigstellung der Laminatschicht ein zweites, anderes Beschichtungsverfahren verwendet wird.

Es ist daher die Aufgabe der vorliegenden Erfindung, eine Schichtverbundfolie mit gleichmäßiger Schichtdicke und verbessertem Schichtaufbau, insbesondere für passive elektronische Bauelemente mit Vielschichtstruktur bereitzustellen.

Eine weitere Aufgabe der Erfindung ist es, ein einfaches Verfahren zur Herstellung solcher Schichtverbundfolien anzugeben.

Die Erfindung ist weiterhin auf die vorteilhafte Verwendung solcher Schichtverbundfolien gerichtet.

Gemäß eines Aspektes der Erfindung wird die Aufgabe gelöst durch die Bereitstellung einer Schichtverbundfolie, insbesondere für passive elektronische Bauelemente mit Vielschichtstruktur, die
a) eine grüne keramische Substratfolie, die ein oder mehrere keramische Komponenten und eine Bindemittelzubereitung enthält,
b) darauf im Siebdruck aufgebrachte innere Elektroden, die ein oder mehrere metallische Komponenten, sowie gegebenenfalls keramische Füller, und ein Bindemittelzubereitung enthalten, und
c) eine oder mehrere ganzflächig über innere Elektroden und grüne keramische Substratfolie im Siebdruck aufgebrachte Ausgleichsschichten, die ein oder mehrere keramische Komponenten und ein Bindemittelzubereitung enthalten, umfaßt.

Diese siebgedruckten Ausgleichsschichten bedecken gleichmäßig die gesamte mit dem Elektrodenmuster bedruckte Fläche der Substratfolie. Sie füllen die Zwischenräume zwischen den inneren Elektroden gleichmäßig aus und bedecken auch in einer dünnen Schicht die inneren Elektroden. Das Verfahren wird deshalb auch als "Print over"-Verfahren bezeichnet. Die erfindungsgemäßen Schichtverbundfolien zeigen eine gleichmäßige Schichtdicke über die gesamte, bedruckte Fläche. Gleichzeitig sind die inneren Elektroden gegen mechanische Schädigung und Verunreinung ihrer Ober fläche geschützt.

Nachdem beim Siebdrucken höherviskose keramische Pasten verwendet werden können, ist die Schwindung der Ausgleichsschichten besonders zwischen den inneren Elektroden gering.

Im Siebdruck aufgebrachten Schichten haben auch immer eine relativ hohe Mikrorauhtiefe. Die im Siebdruck aufgebrachten Ausgleichsschichten verbinden sich daher besonders gut beim Verpressen der Stapel.

Die Schichtverbundfolie nach der Erfindung ist formstabil und in sich etwas flexibel. Sie kann bequem gehandhabt, transportiert und weiterverarbeitet werden.

Wenn die Schichtverbundfolie mehrere siebgedruckte Ausgleichsschichten umfaßt, wird eine Folie mit besonders gleichmäßiger Schichtdicke erhalten.

Bevorzugt nach der Erfindung ist eine Schichtverbundfolie, bei der die chemische Zusammensetzung der keramischen Komponenten der grünen keramischen Substratfolie und der Ausgleichsschicht oder der Ausgleichsschichten gleich ist. Solche Schichtverbundfolien lassen sich problemlos kalzinieren und sintern.

Es kann aber auch bevorzugt sein, daß die chemische Zusammensetzung mindestens einer der keramischen Komponenten der Ausgleichsschicht oder der Ausgleichsschichten verschieden von denen der Substratfolie ist.

Die Zusammensetzung kann beispielsweise so gewählt sein, daß Materialunverträglichkeiten zwischen der Substratkeramik und den inneren Elektroden, z.B. unterschiedliche thermische Ausdehnungskoeffizienten oder wechselseitige Diffusion und Reaktion oder mangelhaftes Benetzungsverhalten, ausgeglichen werden.

Für diesen Fall ist es besonders bevorzugt, daß die Schichtverbundfolie eine ganzflächig im Siebdruck aufgebrachte Ausgleichsschicht, die ein oder mehrere keramische Komponenten und ein Bindemittelzubereitung enthält, zwischen der grünen keramischen Substratfolie und den inneren Elektroden umfaßt.

Eine weitere bevorzugte Ausführung der erfindungsgemäßen Schichtverbundfolie ist dadurch gekennzeichnet, daß die Bindemittelzubereitung der grünen keramischen Substratfolie hydrophil und frei von organischen Lösungsmitteln ist. Solche Schichtverbundfolien sind nicht nur umweltfreundlich, sie haben auch hervorragende Ausbrenneigenschaften und eignen sich somit für extrem schnelle Brennzeiten.

Für eine Schichtverbundfolie, bei der die Bindemittelzubereitung der grünen keramischen Substratfolie hydrophil und frei von organischen Lösungsmitteln ist, ist es bevorzugt, daß die Bindemittelzubereitung der inneren Elektroden und/oder der Ausgleichsschicht oder Ausgleichsschichten hydrophob ist. Durch diese Maßnahme wird erreicht, daß die Substratfolie nicht durch die Lösungsmittel der Bindemittelzubereitung der Siebdruckpasten aufgeweicht wird und die Siebdruckmuster verschmieren.

Im Rahmen der vorliegenden Erfindung ist es bevorzugt, daß das Bindemittel in den besagten Bindemittelzubereitungen einen Zersetzungspunkt ≧ 150°C hat. Diese Bindemittelzubereitungen behalten ihre adhärierende Eigenschaften nach dem abschließenden Trocknen der Schichtverbundfolie. Das erleichtert ihr paßgenaues Stapeln und verbessert die Haftung im Stapel.

Nach einer anderen Ausführungsform der Schichtverbundfolie ist die Bindemittelzubereitung der Substratfolie und/oder der inneren Elektroden und/oder der Ausgleichsschicht oder der Ausgleichsschichten thermoplastisch. Solche Schichtverbundfolien sind ebenfalls umweltfreundlich, weil keine Lösungsmittel für die Bindemittelzubereitungen benötigt werden. Gleichzeitig erhält man auch gleichmäßige Druckergebnisse, weil die Paste sich nicht während des Druckens in ihrer Viskosität verändert. Siebdruckpasten mit thermoplastischen Bindemittelzubereitungen brauchen keine Trockenzeiten, deshalb können mehrere Siebdruckvorgänge schnell hintereinander durchgeführt werden. Schichtverbundfolien mit thermoplastischen Bindemitteln können auch gut gelagert werden, weil sie sich bei Raumtemperatur nicht verändern.

Das erfindungsgemäße Mehrfarbensiebdruckverfahren zur Herstellung von Schichtverbundfolien, insbesondere für passive elektronische Bauelemente mit Vielschichtstruktur, umfasst mindestens die folgenden Schritte:
- eine grüne keramische Substratfolie, die ein oder mehrere keramische Komponenten und ein Bindemittel zubereitung enthält, wird gegebenenfalls mit einer keramischen Siebdruckpaste, die ein-oder mehrere ke ramische Komponenten und ein Bindemittelzubereitung enthält, wobei mindestens eine keramische Komponente der keramischen Siebdruckpaste verschieden von denen der Substratfolie ist, ganzflächig im Siebdruck be druckt,
- ein Elektrodenmuster wird im Siebdruck mit einer Me tallisierungspaste, die ein oder mehrere metallische Komponenten, sowie gegebenenfalls keramische Füller, und ein Bindemittelzubereitung enthält, aufgedruckt,
- die bedruckte grüne keramische Substratfolie wird ein- oder mehrmals ganzflächig mit einer keramischen Siebdruckpaste, die ein oder mehrere keramische Komponenten und eine Bindemittelzubereitung enthält, wobei gegebenenfalls mindestens eine keramische Komponente der keramischen Siebdruckpaste verschieden von denen der Substratfolie ist, im Siebdruck bedruckt.

Dadurch, daß dies Verfahren mehrere gleichartige Verfahrensschritte enthält, läßt es sich leicht automatisieren.

Ein weiterer Aspekt der Erfindung betrifft die vorteilhafte Verwendung der erfindungsgemäßen Schichtverbundfolien zur Herstellung von passiven elektronischen Bauelementen mit Vielschichtstruktur.

Die Erfindung wird nachfolgend unter Bezugnahme auf die beiliegenden Zeichnungen näher erläutert. Es zeigen:
**Fig. 1** die Querschnittsansicht einer erfindungsgemäßen Schichtverbundfolie mit einer Ausgleichsschicht;
**Fig. 2** die Querschnittsansicht einer erfindungsgemäßen Schichtverbundfolie mit zwei Ausgleichsschichten;
**Fig. 3** die Querschnittsansicht eines Schichtstapels für ein passiven elektronisches Bauelements mit Viel schichtstruktur;
**Fig. 4a** das Schliffbild eines passiven elektronischen Bauelementes mit Vielschichtstruktur, hergestellt unter Verwendung der Schichtverbundfolien nach der Erfindung;
**Fig. 4b** das Schliffbild eines passiven elektronischen Bauelementes mit Vielschichtstruktur nach dem Stand der Technik;
**Fig. 5** die schematische Querschnittsansicht eines Vielschichtkondensators;
**Fig. 6** eine Flachformsiebdruckvorrichtung zur Ausführung der erfindungsgemäßen Mehrfarbensiebdruckverfahrens.

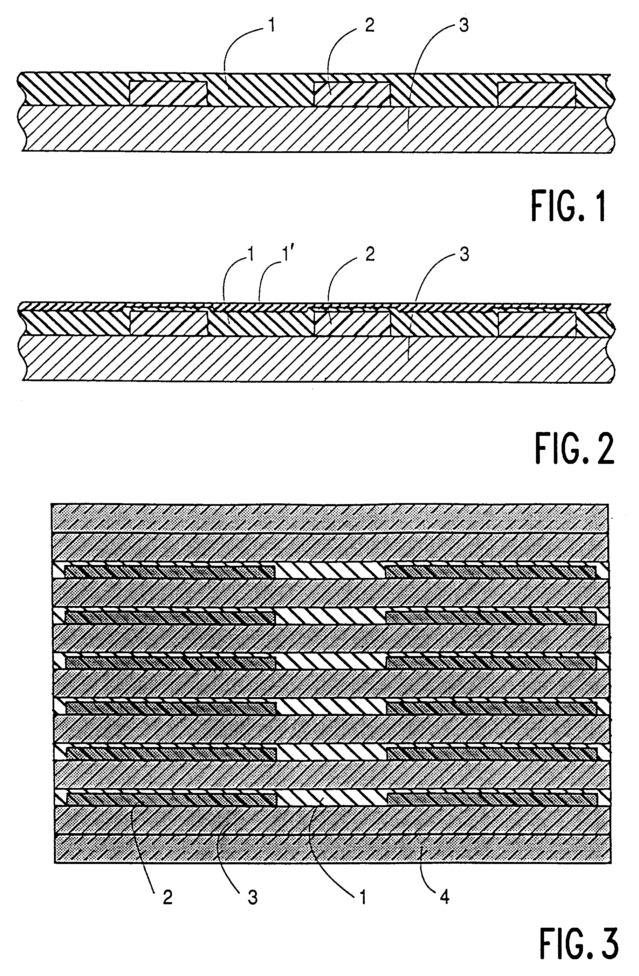

**Fig. 1** zeigt eine Ausführungsform der erfindungsgemäßen Schichtverbundfolie, die eine grüne keramische Substratfolie (3), darauf im Siebdruck aufgebrachte, innere Elektroden (2) und eine ganzflächig über die grüne keramische Substratfolie (3) und die inneren Elektroden (2) im Siebdruck aufgebrachte Ausgleichsschicht (1).

**Fig. 2** zeigt eine andere Ausführngsform der erfindungsgemäßen Schichtverbundfolie mit zwei im Siebdruck aufgebrachten Ausgleichsschichten (1,1a).

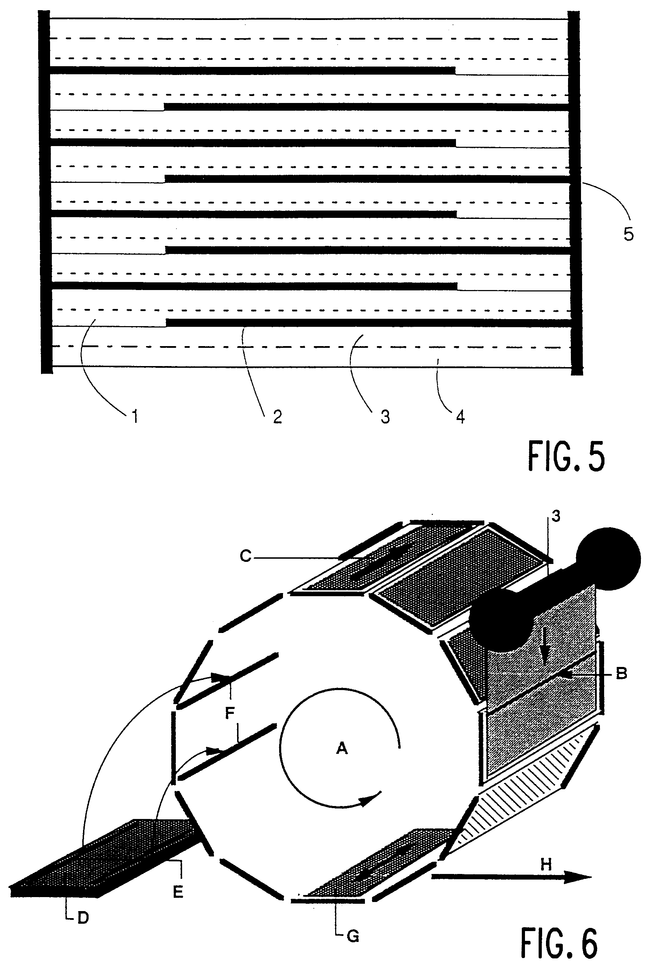

Die Herstellung von passiven elektronischen Bauelementen mit Vielschichtstruktur wie in **Fig. 5** anhand eines Vielschichtkondensators gezeigt, unter Verwendung der erfindungsgemäßen Schichtverbundfolien und des erfindungsgemäßen Mehrfarbensiebdruckverfahrens umfaßt üblicherweise die folgenden Schritte:
1. Präparation der Pulversuspension für die keramische Substratfolie (3),
2. Präparation des Schlickers für die Substratfolie (3),
3. Entgasen des Schlickers im Vakuum,
4. Ziehen, Gießen oder Extrudieren der Substratfolie (3),
5. Trocknen der grünen keramischen Substratfolie (3),
6. gegebenenfalls Siebdrucken einer Ausgleichsschicht (1a) im Flächendruck,
7. Siebdrucken des Musters der inneren Elektroden (2),
8. Siebdrucken von einer oder mehreren Ausgleichsschichten (1,1a) im Flächendruck,
9. gegebenenfalls Aufbringen von Kleber,
10. Trocknen der Schichtverbundfolie,
11. Stapeln der Schichtverbundfolien einschließlich unbedruckter Substratfolien (3) als Deckschichten (4),
11. Laminieren des Stapels, wie in **Fig.3** gezeigt, durch einen Pressvorgang,
12. Separieren von einzelnen Produkten,
13. Ausbrennen des Binders,
14. Sintern,
15. Aufbringen der äußeren Kontakte (5),
16. Endkontrolle.

Die Werkstoffauswahl für die keramischen Komponenten der grünen keramischen Substratfolie richtet sich nach dem Einsatzgebiet. Für passive elektronische Bauelemente verwendet man überwiegend oxidkeramische Komponenten.

Für Vielschichtkondensatoren wird als oxidkeramische Komponente im allgemeinen dotiertes Bariumtitanat verwendet. Die Keramik für Vielschichtaktuatoren basiert im allgemeinen auf einer abgewandelten Bleititanat-Bleizirkonat-Phase, die Keramik der Vielschichtvaristoren auf dotiertem Zinkoxid.

Üblicherweise enthält die keramische Substratfolie (3) neben ihrer durch das Einsatzgebiet vorgegebenen keramischen Hauptkomponente noch weitere keramische Komponenten, die die mechanischen und/oder elektrischen Eigenschaften verbessern sollen, beispielsweise Kornwachstumsinhibitoren oder Sinterhilfsmittel.

Bei einem typischen Fertigungsablauf werden diese Ausgangsstoffe gemischt, gemahlen, kalziniert und erneut zu Pulver vermahlen.

Für die Fertigung der Substratfolien (3) müssen die keramischen Komponenten mit einer Bindemittelzubereitung zu einem Schlicker angerührt werden. Die Wahl des Bindemittels bestimmt auch das Folienfertigungsverfahren und umgekehrt.

Bevorzugt sind im Rahmen der vorliegenden Erfindung Bindemittelzubereitungen, die hydrophil und frei von organischen Lösungsmitteln sind. Der Schlicker besteht dann ausschließlich aus einer wässrigen Suspension, die die keramischen Pulver, die mit dem plastischen Binder beschichtet sind, enthält. Der Schlicker hat daher einen sehr niedrigen Bindemittelgehalt.

Er enthält typischerweise
- als Lösungsmittel destilliertes Wasser,
- als Binder z.B. Acrylpolymere, Methylcellulose oder Polyvinylalkohol,
- als Plastifizierer z.B. gemischte Phtalatester oder Polyethylengykolderivate,
- als Verflüssiger z.b. Metaphoshate oder kondensierte Arylsulfonsäuren und
- als Benetzungsmittels z.B. nichtionisches Octylphenoxyethanol.

Dieser Schlicker wird im Bandgießverfahren weiterverarbeitet. Dazu wird er auf eine Stahltrommel gegossen. Die Foliendicke wird entweder durch die Prozeßparameter, wie die Bandgeschwindigkeit, Gießgeschwindigkeit und Viskosität des Schlickers eingestellt oder durch ein Abstreifrakel begrenzt. Die Folie wird durch einen Trockentunnel geführt.

Nach dem Trocknen haben die Substratfolien, die unter Verwendung von hydrophilen Bindemittelzubereitungen hergestellt wurden, eine gleichmäßige Mikrorißstruktur. Dies hat sich für bestimmte Materialkombinationen von Substratfolie (3), inneren Elektroden (2) und Ausgleichsschicht(1) als günstig für die weiteren Fertigungsschritte erwiesen.

Im Rahmen der vorliegenden Erfindung kann es aber auch bevorzugt sein, die Substratkeramik mit thermoplastischen Bindemittelzubereitungen zu Folien zu verarbeiten. Am häufigsten werden Thermoplaste aus der Gruppe der Polypropylene, Polyethylene oder Polystyrole eingesetzt. Manchmal werden auch Wachse mit höher schmelzenden Thermoplasten kombiniert, um eine zu starke Erweichung und damit Instabilität zu vermeiden. Diese Folien werden aus Breitschlitzdüsen heiß extrudiert.

Die keramischen grünen Substratfolien (3) können nach allen bekannten Verfahren, z.B. im Bandgießverfahren, durch Extrudieren oder Kalandrieren hergestellt werden. Zur besseren Handhabung werden sie üblicherweise bei der Fertigung direkt auf Trägerfolien aufgebracht. Für das erfindungsgemäße Mehrfarbensiebdruckverfahren sind jedoch Trägerfolien nicht erforderlich. Damit entfällt das Abziehen der Trägerfolien vor dem Stapeln und die Fertigungsgenauigkeit beim Stapeln wird verbessert.

Die grünen keramischen Substratfolien (3) werden anschließend im Siebdruckverfahren mit Metallisierungsfarben zur Bildung der inneren Elektroden (2) und mit keramischen Siebdruckfarben zur Bildung der Ausgleichsschicht (1) bzw. den Ausgleichsschichten (1,1a) bedruckt.

Als Metallisierungsfarbe für die inneren Elektroden (2) können handelsübliche Metallisierungspasten verwendet werden. Sie enthalten als metallische Komponente üblicherweise Silber oder Silberlegierungen, wie Silberpalladiumlegierungen, andere Palladiumlegierungen, Goldlegierungen, Nickel oder Kupfer. Es können aber auch andere metallische Komponenten, die beispielsweise titan-, zirkon- oder molybdän/manganhaltig sind, verwendet werden.

Die Metallisierungsfarbe enthält z.B. 20 bis 70% metallische Komponenten, eventuell Zusätze von keramischen Komponenten der Substratfolie (3) und/oder der Ausgleichsschicht (1) oder eines anderen Keramikpulvers. Ein mittlerer Anteil an Harzen, Lacken und anderen organischen Stoffen macht die Farbpaste druckfähig.

Wenn große Unterschiede zwischen dem thermischen Ausdehnungskoeffizienten der Substratkeramik und der metallischen Komponente bestehen, kann dies durch Anteile von Substratkeramikmaterial in der Metallisierungsfarbe ausge glichen werden.

Die keramischen Siebdruckfarben für die Ausgleichsschichten(1,1a) enthalten üblicherweise die gleichen keramischen Komponenten wie die Substratfolie (3).

Für Ausgleichsschichten (1,1a), die Materialunverträglichkeiten zwischen den inneren Elektroden (2) und der Substratfolie (3) ausgleichen soll, können z.B. Silikate als zusätzliche keramische Komponenten eingesetzt werden.

Die Bindemittelzubereitung für die keramischen Siebdruckfarben enthält z.B. ein nichtwässriges Lösungsmittel z.B. Butylglykol, Isopropanol oder Methylisobutylketon, als Binder Cellulosederivate wie Ethylcellulose oder Celluloseacetatbutyrat, oder Polyacrylatester, als Plastifizierer z.B. Polyethylenglykolderivate oder gemischte Phtalatester, als Verflüssiger Fettsäuren oder aromatische Sulfonsäuren und z.B. Polyethylenglykolderivate als Benetzungsmittel.

Durch geeignete Kombination von Bindemitteln und Lösungsmittel kann die Rezeptur für die keramische Siebdruckfarbe so variiert werden, daß sie Viskositäten zwischen 25 und 800 Centipoise besitzt, schnell oder langsam trocknet und sich mehr oder weniger thixotrop verhält. Durch genaue Kontrolle dieser Parameter erhält man optimale Ergebnisse für den Siebdruck der Ausgleichsschichten (1,1a).

Die keramischen Siebdruckfarben können auch weitere Komponenten enthalten, bzw. Faserverstärkung, wodurch eine gewünschte Mikrorißstruktur der Ausgleichsschichten (1,1a) erhalten bleibt, aber die Flexibilität und mechanische Festigkeit der Ausgleichsschichten (1,1a) verbessert wird.

Die thermoplastischen keramischen Siebdruckfarben basieren auf Bindemittelzubereitungen mit Polyvinylalkoholemulsion, Acrylharzen, Polyethylen und anderen Thermoplasten.

Das Mehrfarbensiebdruckverfahren kann mit den bekannten Siebdruckvorrichtungen erfolgen. Siebdruckverfahren haben den Vorteil, daß halb- und vollautomatische Siebdruckmaschinen kommerziell erhältlich sind. Nachdem bei dem erfindungsgemäßen Verfahren die Positionierung der Siebstellung vereinfacht ist, können einfache Tischsiebdruckvorrichtungen genauso wie Rotationssiebdruckmaschinen verwendet werden.

Das Verfahren soll jedoch nachfolgend anhand einer Siebdruckanlage nach **Fig.6** beschrieben werden, die besonders für die Fertigung von passiven elektronischen Bauelementen mit Vielschichtstruktur geeignet ist.

Die Siebe bestehen aus synthetischem oder - insbesondere für thermoplastische Siebfarben- aus metallischem Gewebe, dessen einzelne Fäden sehr fein und rechtwinklig übereinander liegen.

Zunächst werden das Sieb für das Drucken der Elektrodenmuster hergerichtet. Auf das Siebgewebe wird eine lichtempfindliche Schicht aufgetragen. Darauf wird die "Montage", d.h. ein belichteter Photofilm mit einem Negativbild der inneren Elektroden (2), aufgelegt. Dann wird die Schicht belichtet und entwickelt. Dabei bleibt ein Negativbild des Elektrodenmusters als Schablone stehen.

Das Sieb für die Ausgleichsschichten (1,1a) bleibt ohne Schablone.

Diese Siebe werden in die siebdruckmaschine in die Siebdruckposition (C) eingesetzt.

Die grüne keramische Substratfolie (3) wird zunächst abgerollt und gegebenenfalls von der Trägerfolie getrennt und mit einer Schlagschere (B) beschnitten. Die Substratfolie (3) wird in ihrer Position abgelegt und durch eine Vakuumvorrichtung, die sich in der Drucktrommel (A) befindet, festgehalten.

Die druckfertigen Farben werden in der Breite der Schablonen auf das Sieb aufgetragen und mit einem Vorstreichrakel verteilt. Dann wird mit dem Rakel (Winkelstellung 55° bis 70°) die Farbe durch die bildoffenen Stellen des Gewebes auf die darunter befindliche grüne, keramische Substratfolie (3) gedrückt. Dies Durchrakeln muß in einem Zug geschehen. Die Rakelrichtung soll zweckmäßigerweise mit der Schußrichtung des Siebgewebes und der Längsrichtung des Elektrodenmusters laufen.

Für das Siebdrucken mit thermoplastischen Siebdruckfarben (Heißschmelzfarben) müssen sowohl das Sieb als auch die Druckfarbe vorgeheizt und auf Temperatur gehalten werden. Es ist jedoch besonders vorteilhaft für ein Mehrfarbensiebdruckverfahren, weil mehrere Farben unmittelbar hintereinander aufgedruckt werden können, ohne daß Trockenzeiten eingehalten werden müssen. Außerdem werden gleichmäßige Druckergebnisse erhalten, weil sich die Viskosität thermoplastischer Siebdruckfarben nicht durch Lösungsmittelverdampfung verändert.

Nach der Erfindung kann zunächst eine Ausgleichsschicht (1), bei der die chemische Zusammensetzung mindestens einer ihrer keramischen Komponenten verschieden von der denen der Substratfolie (3) ist, aufgedruckt werden.

Üblicherweise wird jedoch zuerst das Muster der inneren Elektroden (2) auf die grüne keramische Substratfolie (3) mit der Metallisierungsfarbe aufgedruckt.

Dann wird das Sieb oder die Druckposition (C) gewechselt und es wird eine Ausgleichsschicht (1) ganzflächig über Substratfolie (3) und innere Elektroden (2) gedruckt.

Wenn nötig, kann eine zweite, sehr dünne Ausgleichsschicht (1a) über die erste gedruckt werden.

Die Oberfläche der Schichtverbundfolie kann noch mit Kleber versehen werden.

Dazu werden aus einem Kleberreservoir (D) mit den Druckstempeln (E) ein Linienraster (F) auf die Schichtverbundfolie aufgetragen.

In der Position (G) werden die fertigen Schichtverbundfolien gestapelt und der Stapel vorgepreßt. Anschließend werden sie getrocknet, laminiert, gekerbt und gebrochen und dann zum Brennen zu den Öfen (H) transportiert.

Der Brenn- und Sinterprozeß wird üblicherweise in einem Kammerofen oder in einem Durchschubofen durchgeführt. Wichtig ist, daß der Ofen ausreichend belüftet und abgesaugt wird, damit während der Austrittsphase von Lösungsmittel und Binder diese entweder in die Abluft gehen oder vollständig ausgebrannt werden.

Bei der erfindungsgemäßen Ausführung erleichtert die geringe Schichtdicke der Schichtverbundfolie und die feine und gleichmäßige Mikrorißstruktur, die beim vorzugsweisen Gebrauch wässriger Bindemittelzubereitungen entsteht, das Austreiben der flüchtigen Bestandteile. Es verbleiben daher keine Kohlenstoffreste im Verbund, die die Eigenschaften der fertigen Bauelemente verschlechtern, oder beim Sintern durch CO²-Bildung stören.

### AUSFÜHRUNGSBEISPIEL

Die keramische Substratfolien (3) werden nach dem Bandgießverfahren hergestellt.

Feinteiliges Pulver aus dotiertem Bariumtitanat wird zusammen mit Ammoniumpolyacrylat (Polymerisationsgrad 60) in Wasser dispergiert.

Dieser Suspension wird eine Lösung, bestehend aus Polyvinylalkohol, Triethylenglykol, sowie Netzmittel, Trennmittel und Wasser unter Rühren zugesetzt. Nach Homogenisierung und Entgasen wird der Schlicker auf ein umlaufendes Stahlband gegossen. Die ausgebreitete Schicht wird durch durch einen beheizten Trockentunnel geführt und als trockene Folie (3) vom Stahlband abgezogen. Nach einer Nachheizung wird die Folie (3) auf eine Trommel gewickelt. Auf diese Weise können sehr dünne keramische Substratfolien (3) hergestellt werden, die grün im Siebdruckverfahren bedruckt werden können.

Die grüne keramische Substratfolie (3) wird auf einer Trommelsiebdruckanlage nach **Fig.6** im Flachdruck zunächst mit der Metallisierungspaste zur Bildung der inneren Elektroden (2) bedruckt. Dazu wird die Substratfolie (3) mit einer Schlagschere (B) zugeschnitten, mit einer Vakuumeinrichtung auf der Trommel (A) gehalten, das Sieb mit dem Druckmuster für die inneren Elektroden wird aufgelegt und die Metallisierungspaste in dicker Lage in die Siebform aufgegeben.
Mit einem Vorstreichrakel wird die Metallisierungspaste zunächst in der Siebform verteilt. Dann wird mit dem Rakel die Metallisierungspaste unter gleichmäßigem Druck über das Sieb gezogen und an den offengehaltenen Stellen auf die Substratfolie gedrückt.

Das Sieb wird gewechselt und die keramische Siebdruckpaste wird mit dem Sieb für die Ausgleichssschichten (1,1a) ohne Druckmuster ohne umständliches Positionieren über die metallisierte Substratfolie (3,2) gedruckt.

Typischerweise hat die grüne keramische Substratfolie (3) eine Dicke von 5-40 Mikron, die grünen, inneren Elektroden (2) von 5,5-8 Mikron und die Ausgleichsschicht (1) eine Höhe von 1,5 bis 3 Mikron, gemessen über den Elektroden (2).

Um die nachfolgenden Schritte des Stapelns und Trennens zu erleichtern, kann auf die fertige grüne Schichtverbundfolie noch Kleber aufgebracht werden. Als Kleber kann eine verdünnte keramische Siebdruckfarbe verwendet werden.

Nach dem Siebdrucken werden Schichtverbundfolien mit gleichem oder unterschiedlichem Druckmuster für die inneren Elektroden gestapelt wie in **Fig. 3** gezeigt, sodaß der richtige Aufbau für die herzustellenden passiven elektronischen Bauelemente mit Vielschichtstruktur entsteht. Die Ober- und Unterseite der Stapel werden mit unbedruckten Substratfolien (3), sogenannten Deckschichten (4), versehen. Diese Deckschichten (4) fungieren als Schutz für den aktiven Teil des fertigen passiven elektronischen Bauteils.

Der Stapel zuerst bei höheren Temperaturen, beispielsweise 85°C, zum Trocknen ausgelagert. Danach werden die Stapel durch Thermokompression bei 80°C, 300MPa, für einige Sekunden zu einer Halbzeugplatte laminiert.

Aus der Platte werden dann die einzelnen Produkte durch Ankerben und Brechen, Schneiden oder Sägen separiert.

Aus diesen grünen Produkten wird Zuerst der Binder ausgebrannt, dann findet die Sinterung der Produkte statt.

Schließlich werden die Produkte mit den äußeren Kontakten versehen, die durch Eintauchen der "aktiven" Seiten, an denen die inneren Elektroden offen liegen, in eine Metallisierungspaste mit anschließendem Trocknen und Sintern angebracht werden.

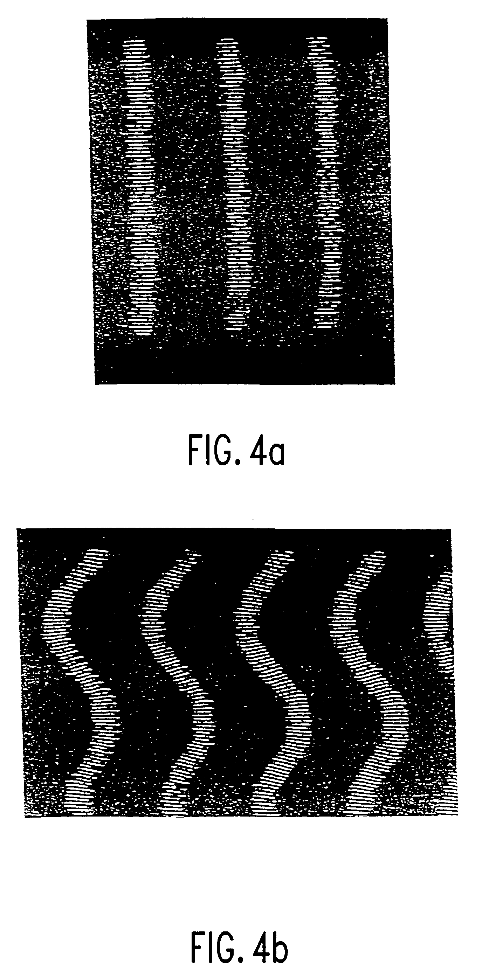

**Fig.4a** zeigt das Schliffbild eines Vielschichtkondensators, der unter Verwendung der erfindungsgemäßen Schichtverbundfolien hergestellt wurde. **Fig.4b** zeigt das Schliffbild eine Vielschichtkondensators nach dem Stand der Technik. Es zeigt sich, daß durch die Verwendung der erfindungsgemäßen Schichtverbundfolien das "chevronning" sicher verhindert werden kann.

## Patentansprüche

1. Schichtverbundfolie, insbesondere für passive elektronische Bauelemente mit Vielschichtstruktur, die
- eine grüne keramischen Substratfolie, die ein oder mehrere keramische Komponenten und eine Bindemittelzubereitung enthält, und
- darauf im Siebdruck aufgebrachte innere Elektroden, die ein oder mehrere metallische Komponenten, sowie gegebenenfalls keramische Füller, und eine Bindemittelzubereitung enthalten, und
- eine oder mehrere ganzflächig über innere Elektroden und grüne keramische Substratfolie im Siebdruck aufgebrachte Ausgleichsschichten, die ein oder mehrere keramische Komponenten und eine Bindemittelzubereitung enthalten, umfaßt.

2. Schichtverbundfolie nach Anspruch 1,
dadurch gekennzeichnet,
daß die chemische Zusammensetzung der keramischen Komponenten der grünen keramischen Substratfolie und der Ausgleichsschicht oder der Ausgleichsschichten gleich ist.

3. Schichtverbundfolie nach Anspruch 1,
dadurch gekennzeichnet,
daß die chemische Zusammensetzung mindestens einer der keramischen Komponenten der Ausgleichsschicht oder der Ausgleichsschichten verschieden von denen der grünen keramischen Substratfolie ist.

4. Schichtverbundfolie nach Anspruch 3,
dadurch gekennzeichnet,
daß sie eine ganzflächig im Siebdruck aufgebrachte Ausgleichsschicht, die ein oder mehrere keramische Komponenten und eine Bindemittelzubereitung enthält, zwischen der grünen keramischen Substratfolie und den inneren Elektroden umfaßt.

5. Schichtverbundfolie nach Anspruch 1 bis 4,
dadurch gekennzeichnet,
daß die Bindemittelzubereitung der grünen keramischen Substratfolie hydrophil und frei von organischen Lösungsmitteln ist.

6. Schichtverbundfolie nach Anspruch 5,
dadurch gekennzeichnet,
daß die Bindemittelzubereitung der inneren Elektroden und/oder der Ausgleichsschicht oder der Ausgleichsschichten hydrophob ist.

7. Schichtverbundfolie nach Anspruch 1 bis 8,
dadurch gekennzeichnet,
daß das Bindemittel in der Bindemittelzubereitung einen Zersetzungspunkt ≧ 150°C hat.

8. Schichtverbundfolie nach Anspruch 1 bis 4,
dadurch gekennzeichnet,
daß die Bindemittelzubereitung der grünen keramischen Substratfolie und/oder der inneren Elektroden und/oder der ganzflächig im Siebdruck aufgebrachten Ausgleichsschichten thermoplastisch ist.

9. Mehrfarbensiebdruckverfahren zu Herstellung von Schichtverbundfolien, insbesondere für passive elektronische Bauelemente mit Vielschichtstruktur,
mit mindestens den folgenden Schritten:
- eine grüne keramische Substratfolie, die ein oder mehrere keramische Komponenten und ein Bindemittelzubereitung enthält, wird gegebenenfalls mit einer keramischen Siebdruckpaste, die ein oder mehrere keramische Komponenten und ein Bindemittelzubereitung enthält, wobei mindestens eine keramische Komponente der keramischen Siebdruckpaste verschieden von denen der Substratfolie ist, ganzflächig im Siebdruck bedruckt,
- ein Elektrodenmuster wird im Siebdruck mit einer Metallisierungspaste, die ein oder mehrere metallische Komponenten, sowie gegebenenfalls keramische Füller, und ein Bindemittelzubereitung enthält, aufgedruckt,
- die bedruckte, grüne keramische Substratfolie wird ein- oder mehrmals ganzflächig mit einer keramischen Siebdruckpaste, die ein oder mehrere keramische Komponenten und eine Bindemittelzubereitung enthält, wobei gegebenenfalls mindestens eine keramische Komponente der keramischen Siebdruckpaste verschieden von denen der Substratfolie ist, im Siebdruck bedruckt.

10. Verwendung der Schichtverbundfolien nach Anspruch 1 bis 8 für passive elektronischen Bauelementen mit Vielschichtstruktur.
